# EUROPÄISCHE PATENTSCHRIFT

(11) **EP 2 294 628 B1**
(45) Veröffentlichungstag und Bekanntmachung des Hinweises auf die Patenterteilung: **03.10.2012**
(21) Anmeldenummer: 09742110.1
(22) Anmeldetag: 07.05.2009
(51) Int. Cl.: H01L 31/052

(54) **Vorrichtung und Verfahren zum Konzentrieren von einfallendem Licht**
Device and method for concentrating incident light
Dispositif et procédé de concentration de lumière incidente

(30) Priorität: 07.05.2008 DE 102008001640; 19.04.2009 DE 102009002473
(43) Veröffentlichungstag der Anmeldung: 16.03.2011
(73) Patentinhaber: Draheim, Peter, 25462 Rellingen (DE)
(72) Erfinder: DRAHEIM, Robert, 22307 Hamburg (DE); DRAHEIM, Peter, 25462 Rellingen (DE)
(74) Vertreter: Gerbaulet, Hannes
(86) Internationale Anmeldenummer: PCT/EP2009/055509
(87) Internationale Veröffentlichungsnummer: WO 2009/135892

(56) Entgegenhaltungen:
- EP-A2- 0 116 521
- EP-A2- 0 200 496
- EP-A2- 1 715 260
- US-A- 4 131 485
- US-A- 4 148 299
- US-A1- 2005 046 977
- US-A1- 2008 047 605

## Beschreibung

### Technisches Gebiet

Die vorliegende Erfindung betrifft eine zum Konzentrieren von einfallendem Licht, insbesondere von Sonnenlicht, vorgesehene Vorrichtung, aufweisend mindestens einen statisch montierten rinnen- oder wannenförmigen Spiegelkörper, mittels dessen das einfallende Licht auf mindestens ein *in Bezug auf den Spiegelkörper statisch* montiertes photovoltaisches Absorbermittel, insbesondere auf mindestens eine Solarzelle, zum Beispiel auf mindestens eine Solarzellenplatte oder auf mindestens einen Solarzellenriegel, umlenkbar ist. (vgl. Druckschriften EP 1 715 260 A2, EP 0 200 496 A2, US 4 131485, US 200510046977 A1 *oder* EP 0 116 521 A2 aus dem Stand der Technik).

Die vorliegende Erfindung betrifft des Weiteren ein entsprechendes Verfahren zum Konzentrieren von einfallendem Licht, insbesondere von Sonnenlicht.

Hierbei soll vorstehend sowie im Folgenden unter einfallendem Licht dasjenige Licht verstanden werden, das durch die von außerhalb der Vorrichtung auftreffenden Lichtstrahlen, insbesondere durch die von außen auftreffenden Sonnenstrahlen, gebildet wird.

In diesem Zusammenhang wird jedoch im Rahmen der vorliegenden Erfindung unter dem Begriff Licht nicht nur der für das Auge sichtbare Bereich der elektromagnetischen Strahlung verstanden, der sich in einem Wellenlängenbereich von etwa 380 Nanometer bis etwa 780 Nanometer erstreckt (, was einer Frequenz von etwa 789 Terahertz bis herab zu etwa 385 Terahertz entspricht); vielmehr wird unter dem Begriff Licht das gesamte, also auch das für das Auge nicht sichtbare elektromagnetische Wellenlängen- bzw. Frequenzspektrum verstanden, insbesondere
- der I[nfra]R[ot]-Bereich (Wellenlängenbereich bis zu etwa 2.000 Nanometer bzw. Frequenzbereich bis herab zu etwa 150 Terahertz) und
- der U[Itra]V[iolett]-Bereich (Wellenlängenbereich bis herab zu etwa einem Nanometer bzw. Frequenzbereich bis zu etwa 300 Petahertz).

### Stand der Technik

Konventionelle, sich heutzutage im Einsatz befindliche planare Photovoltaiksysteme weisen großflächige Siliziummodule auf und sind in der Herstellung sehr kostspielig, wobei die Produktionskosten zur Zeit durch die Kosten des Siliziums bestimmt sind.

Hierbei beträgt der Kostenanteil des Photovoltaikmaterials (bei vergleichbarem mechanischem Aufbau und bei vergleichbarer Masse von etwa zehn Kilogramm pro Quadratmeter) an den Modulen
- bei monokristallinem Silizium (mit einem Wirkungsgrad von etwa sechzehn Prozent bis etwa zwanzig Prozent und mit einem Marktpreis von etwa 500 EUR pro Quadratmeter) etwa sechzig Prozent,
- bei polykristallinem Silizium (mit einem Wirkungsgrad von etwa zehn Prozent bis etwa fünfzehn Prozent und mit einem Marktpreis von etwa 350 EUR pro Quadratmeter) etwa vierzig Prozent und
- bei amorphem Silizium (mit einem Wirkungsgrad von etwa acht Prozent bis etwa zehn Prozent und mit einem Marktpreis von etwa 250 EUR pro Quadratmeter) oder bei anderen Halbleiter-Dünnschichtmaterialien etwa zwanzig Prozent.

Aus diesem Grunde kommen in letzter Zeit vermehrt Photovoltaikkonzentratoren zum Einsatz; hierbei werden als Konzentratoren der Lichtbündelung dienende Vorrichtungen der geometrischen Optik bezeichnet, mittels derer eine Vervielfachung der Strahlungsdichte und mithin eine Minimierung von Absorberveriusten erzielbar ist. Aufgrund des erhöhten Wirkungsgrads der photovoltaischen Systeme kann durch eine verringerte Fläche an Solarzellen der Siliziumkostenanteil reduziert und damit das Verhältnis der Solarzellenkosten zu den Gesamtkosten gesenkt werden; als Solarzellenmaterial können hierbei abgesehen von Silizium auch III/IV-Halbleiter, wie etwa Galliumarsenid (GaAs) oder Indiumphosphid (InP), verwendet werden.

Derartige mit Spiegeln und/oder mit Linsen unterschiedlichster Art, zum Beispiel mit parabolischen Spiegeln und/oder Linsen, aufgebaute Konzentratorsysteme reduzieren zwar das Problem der hohen Halbleitermaterialkosten, insbesondere der hohen Siliziumkosten oder der hohen Galliumarsenidkosten, um den Konzentrationsfaktor des Konzentrators (Faktor größer als 1 bis zu Faktor 1.000); jedoch sind derartige Konzentratorsysteme mit einem wesentlich höheren mechanischen Aufwand verbunden, denn diese Art der Lichtkonzentration erfordert eine relativ komplexe mechanische Nachführung.

Zumindest in Mittel- und Nordeuropa haben sich derartige Konzentratoren aufgrund des dortigen wolkigen Klimas bislang noch nicht durchgesetzt, denn Konzentratoren nutzen hauptsächlich die direkte Strahlung. Obwohl der Anteil der diffusen Strahlung an der Gesamtstrahlung bis zu fünfzig Prozent betragen kann, bleibt die diffuse Strahlung zumindest in nachgeführten Konzentratoren zumeist ungenutzt.

Hierbei wird hinsichtlich der Bauform von Photovoltaikkonzentratoren primär zwischen statischen Systemen und nachgeführten Systemen unterschieden. Statische Konzentratoren werden wie übliche Flach- oder Planarkollektoren fest montiert, weisen aber bauartbedingt ein Konzentrationsverhältnis auf, das mit zunehmendem Akzeptanzwinkel der Strahlung abnimmt. Hierbei wird unter dem Akzeptanzwinkel der maximale Einfallswinkel verstanden, in dem die der Strahlung aufgenommen werden kann.

Durch den großen Akzeptanzwinkel ist bei statischen Photovoltaiksystemen jedoch eine begrenzte Nutzung des diffusen Lichts möglich. Typischerweise liegt das Konzentrationsverhältnis bei eindimensionalen statischen Konzentratoren im Bereich bis etwa 2. Aus diesem Grunde sind der Platzbedarf und der Herstellungsaufwand bezogen auf den Konzentrationsfaktor relativ hoch.

Nachgeführte Photovoltaiksysteme erreichen Konzentrationsfaktoren von über 100, allerdings ist hierfür eine sehr aufwändige Mechanik und Steuerung erforderlich; dies gilt insbesondere für zweiachsig nachgeführte Systeme, so dass sich die Entwicklung derartiger nachgeführter Photovoltaiksysteme hauptsächlich auf große Anlagen beschränkt.

Durch die hohe Windlast ist bei nachgeführten Photovoltaiksystemen eine stabile Abstützung erforderlich, so dass nachgeführte Konzentratoren typischerweise einen hohen Flächenbedarf aufweisen und eine Integration in Gebäuden kaum möglich ist.

Obwohl auch diffuses Licht eine gewisse Helligkeit im Konzentrator erzeugt, können des Weiteren hochkonzentrierende nachgeführte Photovoltaiksysteme diese diffuse Strahlung kaum nutzen und eignen sich somit hauptsächlich für sonnige Klimazonen, zum Beispiel in Südeuropa.

Prinzipiell können nachgeführte Systeme mit höherem Akzeptanzwinkel konzipiert werden, um schräg einfallendes Licht oder Streulicht zu nutzen. Allerdings verringert sich dann das Konzentrationsverhältnis und somit die Ausnutzung der direkten Strahlung. Hierdurch steigt der relative Mehraufwand für die Nachführung und für die Fixierung.

Ausgehend davon, dass für kleine bis mittlere Photovoltaiksysteme vor allem in wolkigeren Klimazonen das Problem zugrunde liegt, dass statische Konzentratoren zu niedrige Konzentrationsverhältnisse erreichen, nachgeführte Konzentratoren jedoch einen sehr hohen Aufwand für Nachführung und für Fixierung benötigen, wird in der Druckschrift DE 202 20 390 U1 ein semistatischer Photovoltaik-Konzentrator vorgeschlagen, bei dem das Grundelement ein statischer, fest montierter Spiegel ist, wohingegen der Absorber mit den Solarzellen parallel zur Brennebene verschiebbar ist, wodurch die Fokussierung auf die Absorberfläche erreicht wird.

Aus der Druckschrift US 4 148 299 A ist eine Anordnung für einen statischen Photovoltaik-Konzentrator bekannt, bei der ein Absorber zwischen zwei sphärische konzentrierende Strukturen platziert wird, womit eine Nachführungsfreiheit durch Mehrfachreflexionen erreicht wird.

Aus der Druckschrift WO 89/05520 A1 ist eine Anordnung bekannt, bei der bei einem Solarzellenmodul mehrere beidseitig wirksame Solarzellen vorgesehen sind, die über einer Anordnung aus mehreren parallel zueinander verlaufenden rinnenförmigen und im Querschnitt halbkreisförmigen Spiegeln angeordnet sind; diese Spiegel lenken den neben den Solarzellen einfallenden Teil der Solarstrahlung auf die Unterseite der Solarzellen um.

In der Druckschrift EP 0 059 464 A1 ist ein Solarkonzentrator mit einem Hohlspiegel offenbart, der die Sonnenstrahlung auf eine zwischen dem Spiegel und der Sonne befindliche Absorberfläche konzentriert. Der Spiegel wird von einem massiven Block durchsichtigen Materials gebildet, dessen Unterseite konvex gebogen und verspiegelt ist. In oder auf der Oberseite des Blocks ist die Absorberfläche angeordnet.

Aus der Druckschrift DE 195 08 071 A1 ist eine Anordnung bekannt, bei der bei einer Solarzelle nach dem Prinzip der Thermovoltaik durch die Konzentration der Sonnenstrahlen im Brennpunkt oder in der Brennlinie einer spiegelnden Hohlrinne eine höhere Energieausbeute als bei flacher Anordnung der Zellen erreicht wird.

Weitere Konzentratorsysteme aus dem Stand der Technik sind in den Druckschriften US 4 115 149, US 4 173 968, US 4 191 164, US 4 388 481, US 5 062 899, US 5 344 496, WO 78100019 A1, WO 83/01292 A1, WO 90/10182 A1, WO 96/24014 A1, WO 97/00408 A2 und WO 2004/109195 A2 offenbart.

Den vorstehend diskutierten Konzentratorsystemen ist ihr Effizienzverlust bei Temperaturerhöhung im Betrieb sowie auch die Widerstandserhöhung der Solarzellen bei Teilabschattung gemeinsam. Die Widerstandserhöhungen durch Wärme und/oder durch Teilabschattung ziehen eine Reduktion der Stromerzeugung nach sich, denn die Solarelemente sind in Reihe geschaltet.

Zusammenfassend kann festgestellt werden, dass die bekannten Konzentratorsysteme mechanisch komplex sind und einen hohen Wartungsaufwand erfordern, wohingegen die heutzutage erhältlichen planaren Systeme infolge des hohen Siliziumaufwands zu teuer sind.

Daneben gibt es auch Systeme, die aus Polysilizium-Photovoltaikmodulen und/oder aus Dünnschicht-Photovoltaikmodulen aufgebaut sind. Ein derartiger Aufbau ist zwar preiswerter als ein Aufbau aus Silizium-Photovoltaikmodulen, hat jedoch regelmäßig einen geringeren Wirkungsgrad.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Stands der Technik liegt der vorliegenden Erfindung die Aufgabe zugrunde, eine Vorrichtung der eingangs genannten Art sowie ein Verfahren der eingangs genannten Art so weiterzubilden, dass eine signifikante Kostenreduktion durch Einsatz eines Konzentratorsystems ohne bewegliche Teile erzielbar ist.

Diese Aufgabe wird durch eine Vorrichtung mit den im Anspruch 1 angegebenen Merkmalen sowie durch ein Verfahren mit den im Anspruch 11 angegebene Merkmalen gelöst. Vorteilhafte Ausgestaltungen und zweckmäßige Weiterbildungen der vorliegenden Erfindung sind in den Unteransprüchen gekennzeichnet.

Die vorliegende Erfindung basiert grundsätzlich auf der Ausnutzung der Defokussierung von Lichteinstrahlung; dies bedeutet bei konkaven, insbesondere sphärisch gewölbten oder parabolisch gewölbten, Spiegeln die Anordnung der photovoltaischen Absorber oder Solarzellen unterhalb des Brennpunkts. Alternativ oder ergänzend hierzu können die photovoltaischen Absorber oder Solarzellen zwischen dem Brennpunkt des Spiegels und dem Scheitelpunkt des Spiegels angeordnet sein.

Bei sphärischen Spiegeln wird dieser Effekt durch die sphärische Aberration und die dadurch hervorgerufene Kaustik in sehr wesentlicher Weise unterstützt (zum Phänomen der Kaustik vgl. zum Beispiel
- http:/lde.wiipedia.org/wikilKaustik_(Optik),
- das von Carl Ernst Heinrich Grimsehl, Walter Schallreuter und Rudolf Seeliger verfasste "Lehrbuch der Physik", Band 3: Optik, Verlag Teubner, 14. Auflage (1962),
- das von Henrik Wann Jensen verfasste Buch "Realistic Image Synthesis Using Photon Mapping", Verlag A.K. Peters, Wellesley (Juli 2001) oder
- das Manuskript zum von Johannes Kofler, Institut für Angewandte Physik der Johannes-Kepler-Universität Linz, am 31. März 2005 gehaltenen Vortrag "Lichtfokussierung durch Mikrokugeln").

Die Form eines Parabolspiegels wird bei kleinen Öffnungswinkeln gut durch eine sphärische Spiegelform angenähert. Ein Parabolspiegel weist zwar im eigentlichen Sinne keine Kaustik auf, jedoch entsteht ebenfalls eine Brennfläche, wenn das zu beleuchtende Objekt, also die Solarzelle, unterhalb des Brennpunkts angebracht wird.

Im Gegensatz dazu wird bei der vorliegenden Erfindung der Kaustikeffekt eines sphärischen Spiegels oder der Mischform eines sphärisch-parabolischen Spiegels für Konzentratoren in der Photovoltaik genutzt.

Der sphärische bzw. sphärisch-parabolische Spiegel kann hierbei in bevorzugter Weise die Form einer Rinne oder einer Kugelkalotte aufweisen, wobei der als Folge des Kaustikeffekts wandernde Brennpunkt des sphärischen bzw. sphärisch-parabolischen Spiegels zum Vorteil der vorliegenden Erfindung eingesetzt wird.

Wird also bei einem sphärischen bzw. sphärisch-parabolischen Konzentratorspiegel dessen Kaustik ausgenutzt, so ist nicht nur eine Reduktion der Siliziumkosten bei gleich bleibender Energieausbeute möglich, sondern auch ein Konzentrieren des einfallenden Lichts ohne Nachführung des Konzentrators (, so dass keine zusätzlichen Kosten für eine etwaige Spiegelnachführung entstehen).

Die Kaustik des sphärischen Konzentratorspiegels ermöglicht hierbei Verstärkungsfaktoren bis zur Größenordnung der Geometriefaktoren (, wobei unter dem Geometriefaktor das Verhältnis der Offnungsfläche des konzentrierenden Spiegels und damit des maximalen Lichteinfalls zur Fläche der im Spiegel eingesetzten Photovoltaikabsorber verstanden wird):
- ohne Nachführung: Toleranzwinkel von etwa ± zehn Grad oder größer;
- mit unterstützender (konzentrierender) Optik direkt vor dem photovoltaischem Material: Toleranzwinkel von etwa ± fünfzehn Grad oder größer.

Da das photovoltaische Absorbermittel in Bezug auf den Spiegelkörper erfindungsgemäß statisch montiert ist, ist für die erfindungsgemäße Photovoltaik-Konzentratorvorrichtung kein mechanisch-technologisch aufwändiges Herstellungsverfahren erforderlich; vielmehr ist der mechanische Aufwand zur Herstellung, insbesondere zur mechanischen Aufhängung, der einzelnen Module vergleichbar mit dem oder geringer als der mechanische Aufwand zur Herstellung heutzutage erhältlicher planarer Systeme.

Infolge der Nutzung der Kaustik und der dadurch hervorgerufenen Brennfläche mindestens einer auf einfache Weise bereitstellbaren sphärischen oder annähernd parabolischen Spiegelfläche weist die vorliegende Erfindung in bevorzugter Weiterbildung weder komplizierte Linsensysteme noch geschliffene Oberflächen auf. Hierdurch wird ein mechanisch stabiler modularer Aufbau ohne bewegliche Teile ermöglicht, so dass eine Wartungsfreiheit des Gesamtsystems gegeben ist.

Gemäß einer vorteilhaften Weiterbildung der vorliegenden Erfindung kann durch eine wannenförmigen Ausgestaltung der sphärischen oder parabolischen Spiegelfläche eine signifikante Reduktion der Abschattung erzielt werden. Hierbei kann die aktive Seite der Solarzellen mit Vorteil der Spiegelfläche zugewandt sein, also in das Innere des Spiegels gerichtet sein.

Demzufolge kann eine direkte Abschattung innerhalb der erfindungsgemäßen Photovoltaik-Konzentratorvorrichtung reduziert werden, so dass die Effizienz der Anordnung gemäß der vorliegenden Erfindung gesteigert werden kann.

Aufgrund der vorzugsweise planaren Oberfläche des Konzentratorsystems gemäß der vorliegenden Erfindung kann der Spiegel fest auf einem Gebäude, vorzugsweise auf dem Dach eines Gebäudes, montiert werden. Aufgrund der statischen Montage kann das Konzentratorsystem gemäß der vorliegenden Erfindung sogar einen Teil des Dachs ersetzen, was wiederum einen erheblichen Kostenvorteil darstellt.

In zweckmäßiger Weise entspricht die Bauhöhe des Konzentrators in etwa dem halben Radius des sphärischen Spiegels. Dies bedeutet beispielsweise bei einem Radius des sphärischen Spiegels von acht Zentimetern eine ungefähre Bauhöhe des Konzentrators von vier Zentimetern, was der Bauhöhe heutiger planarer Systeme entspricht.

Da die erzielbare Leistung von Solarzellen mit steigender Temperatur sinkt, ist es zweckmäßig, bei der Konzentratorvorrichtung gemäß der vorliegenden Erfindung für eine ausreichende Kühlung des Absorbers zu sorgen, zum Beispiel mittels mindestens eines im optischen Körper integrierten Wärmeabführungssystems, durch das eine wesentliche Steigerung der Effizienz des Photovoltaikprozesses oder -vorgangs erreicht werden kann.

Hierzu kann mindestens ein Kühlsystem, zum Beispiel mindestens ein in das optische System integrierter Kühlkörper, und/oder mindestens eine aktive Kühlung vorgesehen sein, bei der der Photovoltaikabsorber durch ein vorbei fließendes Kühlmittel gekühlt wird.

Insgesamt zeichnet sich die vorliegende Erfindung durch einen Konzentratoreffekt in einem Körper oder Hohlkörper aus optisch transparentem Material auf, wobei es sich um ein mechanisch einfach herstellbares und ohne großen Aufwand montierbares System ohne mechanische Nachführung handelt.

Die vorliegende Photovoltaikkonzentratorvorrichtung weist eine Fokussierung auf eine Brennebene bzw. -fläche und/oder unterhalb einer Brennebene bzw. -fläche auf, wobei zumindest im Falle des Einsatzes einer sphärischen Verspiegelung des optischen Körpers zusätzlich die Wirkung der Kaustik zum Tragen kommt. Eine zweckmäßige Lage oder Positionierung der Photovoltaikmodule zwischen dem Brennpunkt des Spiegelkörpers und dem Scheitelpunkt des Spiegelkörpers sowie die Formgebung der Photovoltaikmodule bestimmen die Grö-βe der Verstärkung und des Akzeptanzwinkels.

Gemäß einer vorteilhaften Weiterbildung der vorliegenden Erfindung können die Photovoltaikabsorber oder Photovoltaikmodule auch auf mehr als einer Seite(nfläche), insbesondere auf beiden oder allen Seiten(flächen), der Absorber- oder Modulhalterung angeordnet sein. Auf diese Weise kann direkt einfallendes Licht, das ansonsten durch die Photovoltaikabsorber oder Photovoltaikmodule abgeschirmt würde, zusätzlich erfasst werden.

In zweckmäßiger Weise kann mittels mindestens eines dem Absorbermaterial oder Absorbermittel in Richtung des einfallenden Lichts vorgelagerten oder vorgeschalteten oder vorgesetzten lichtbrechenden, insbesondere optisch transparenten, Elements, zum Beispiel mittels mindestens einer Linse oder mittels mindestens eines Prismas, der durch die Kaustik bedingte Akzeptanzwinkel vergrößert werden.

Mittels der vorliegenden Erfindung ist eine Vervielfachung der Strahlungsdichte und mithin eine Minimierung von Verlusten im Photovoltaikabsorber erzielbar, womit eine Kostenreduktion der Photovoltaikmodule gegenüber konventionellen Systemen einhergeht.

Die vorliegende Erfindung betrifft des Weiteren ein Photovoltaikfeld, ein Photovoltaikpanel oder eine Photovoltaikplatte, aufweisend mehrere Vorrichtungen gemäß der vorstehend dargelegten Art, die modulartig zum Feld, zum Panel bzw. zur Platte zusammengesetzt sein können und zweckmäßigerweise eine gemeinsame optisch transparente Abdeckung aufweisen.

Die vorliegende Erfindung betrifft schließlich die Verwendung mindestens einer Vorrichtung gemäß der vorstehend dargelegten Art und/oder mindestens eines Photovoltaikfelds, mindestens eines Photovoltaikpanels oder mindestens einer Photovoltaikplatte gemäß der vorstehend dargelegten Art zum Konzentrieren von einfallendem Licht, insbesondere von Sonnenlicht, auf mindestens ein photovoltaisches Absorbermittel, insbesondere auf mindestens eine Solarzelle, zum Beispiel auf mindestens eine Solarzellenplatte oder auf mindestens einen Solarzellenriegel.

Hierdurch ist im Vergleich zu bestehenden Photovoltaiksystemen, insbesondere zu bestehenden Photovoltaikmodulen, eine erhebliche Kostenreduktion erzielbar, wobei für den Photovoltaikkonzentrator keinerlei Nachführung erforderlich ist. Durch eine vorteilhafterweise abgeschlossene und/oder planare Oberfläche ist die Vorrichtung gemäß der vorliegenden Erfindung und/oder das Photovoltaikfeld, das Photovoltaikpanel oder die Photovoltaikplatte gemäß der vorliegenden Erfindung für die Dachmontage geeignet.

### Kurze Beschreibung der Zeichnungen

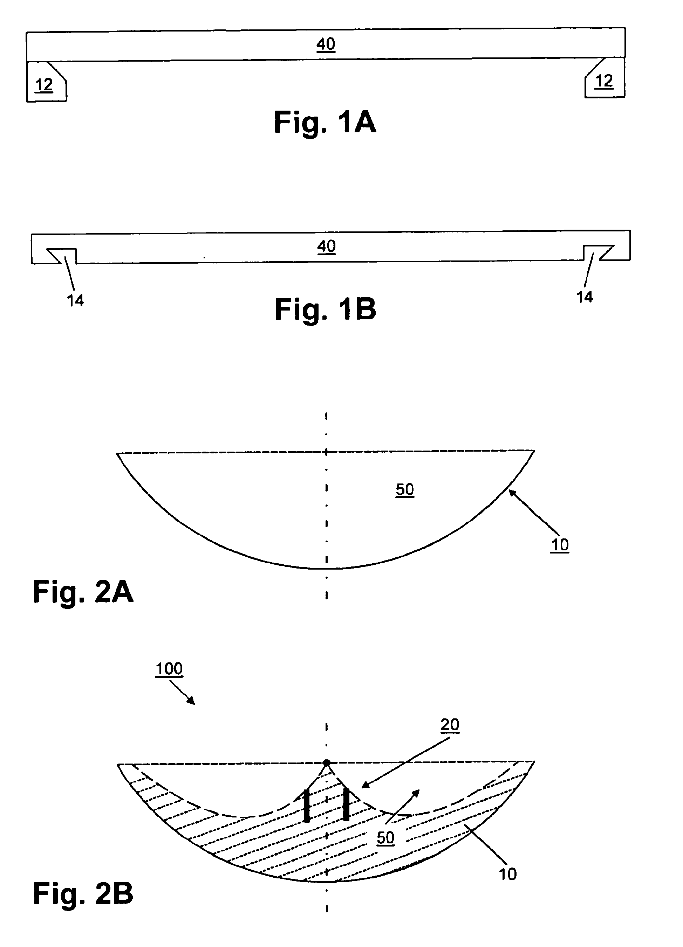

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 nachgeordneten Ansprüche verwiesen, andererseits werden weitere Ausgestaltungen, Merkmale und Vorteile der vorliegenden Erfindung nachstehend anhand der durch Fig. 1A bis Fig. 4C veranschaulichten Ausführungsbeispiele näher erläutert.

Es zeigt:
- Fig. 1 A: in schematischer Querschnittdarstellung ein Herstellungsbeispiel für einen Spiegelkörper einer Vorrichtung gemäß der vorliegenden Erfindung;
- Fig. 1B: in schematischer Querschnittdarstellung ein alternatives Herstellungsbeispiel für einen Spiegelkörper einer Vorrichtung gemäß der vorliegenden Erfindung;
- Fig. 2A: in schematischer Querschnittdarstellung einen Bestandteil eines Ausführungsbeispiels für eine Vorrichtung gemäß der vorliegenden Erfindung;
- Fig. 2B: in schematischer Querschnittdarstellung ein erstes Ausführungsbeispiel für eine Vorrichtung gemäß der vorliegenden Erfindung sowie der diesbezüglichen Kaustik;
- Fig. 2C: in schematischer Querschnittdarstellung einen Brennpunkt im sphärischen Spiegel bei senkrecht einfallendem Licht;
- Fig. 2D: in schematischer Querschnittdarstellung eine konventionelle Kaustik;
- Fig. 2E: in schematischer Querschnittdarstellung einen Brennpunkt im sphärischen Spiegel bei schräg einfallendem Licht;
- Fg. 2F: in schematischer Querschnittdarstellung eine Brennpunktüberlagerung bei senkrecht und schräg einfallendem Licht;
- Fig. 2G: in schematischer Querschnittdarstellung die konventionelle Kaustik aus Fig. 2D mit leichter Abweichung von sphärischer Form in Richtung parabolischer Form in den äußeren Randbereichen des Spiegelkörpers;
- Fig. 2H: in schematischer Querschnittdarstellung die konventionelle Kaustik aus Fig. 2D und aus Fig. 2G mit photovoltaischen Absorbermitteln derart angeordnet, dass keine Nachführung erforderlich ist;
- Fig. 21: in schematischer Querschnittdarstellung die konventionelle Kaustik aus Fig. 2D, aus Fig. 2G und aus Fig. 2H mit gemäß dem Sonnenstand wanderndem Brennpunkt;

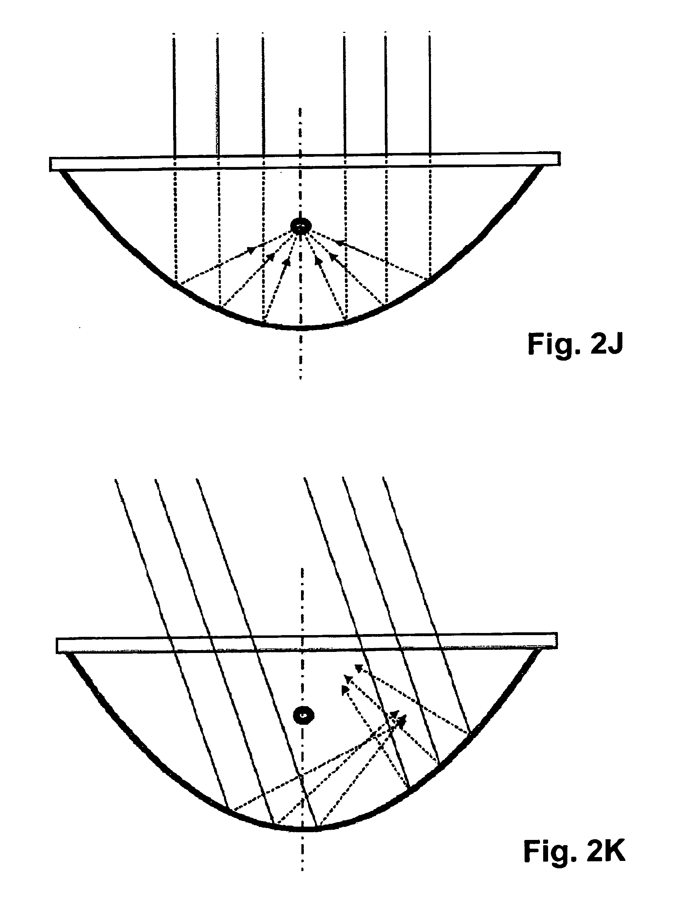

- Fig. 2J: in schematischer Querschnittdarstellung einen konventionellen Brennpunkt im Parabolspiegel bei senkrecht einfallendem Licht;
- Fig. 2K: in schematischer Querschnittdarstellung einen konventionellen Brennpunkt im Parabolspiegel bei schräg einfallendem Licht;

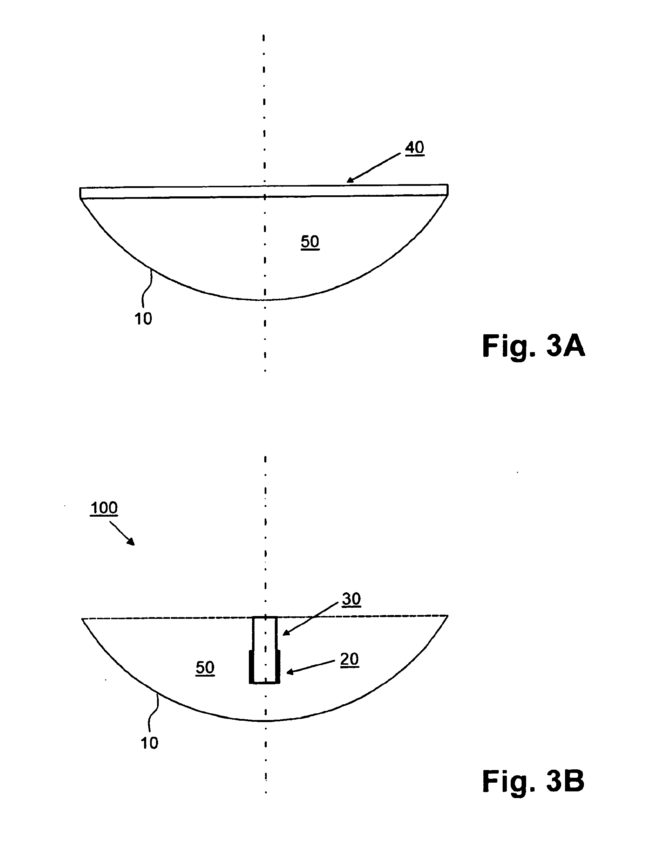

- Fig. 3A: in schematischer Querschnittdarstellung einen Bestandteil eines Ausführungsbeispiels für eine Vorrichtung gemäß der vorliegenden Erfindung;
- Fig. 3B: in schematischer Querschnitfdarstellung ein zweites Ausführungsbeispiel für eine Vorrichtung gemäß der vorliegenden Erfindung;

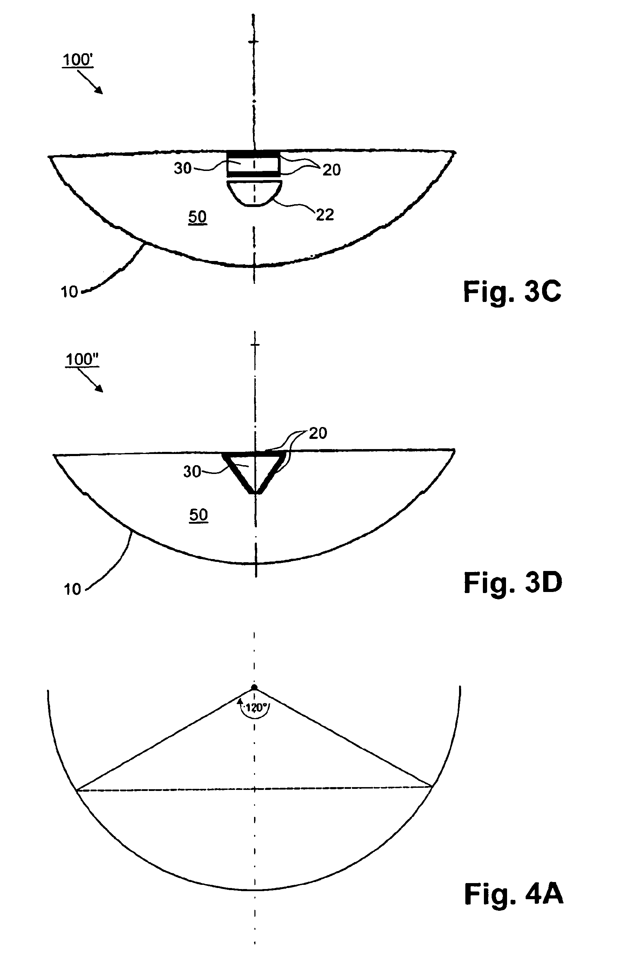

- Fig. 3C: in schematischer Querschnittdarstellung ein drittes Ausführungsbeispiel für eine Vorrichtung gemäß der vorliegenden Erfindung;
- Fig. 3D: in schematischer Querschnittdarstellung ein viertes Ausführungsbeispiel für eine Vorrichtung gemäß der vorliegenden Erfindung;

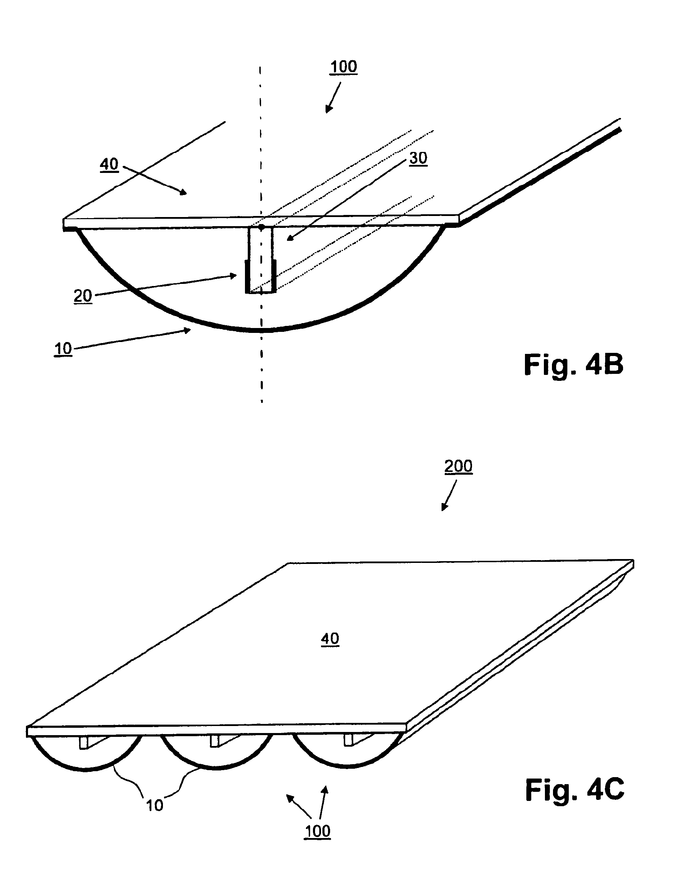

- Fig. 4A: in schematischer Querschnittdarstellung die Berechnungsgrundlage für die Vorrichtung aus Fig. 4B;
- Fig. 4B: in schematisch-perspektivischer Querschnittdarstellung die mit einer Abdeckung in Form einer Deckplatte versehene Vorrichtung aus Fig. 3B; und
- Fig. 4C: in schematisch-perspektivischer Querschnittdarstellung ein Ausführungsbeispiel für ein Konzentratorfeld oder -panel gemäß der vorliegenden Erfindung.

Gleiche oder ähnliche Ausgestaltungen, Elemente oder Merkmale sind in Fig. 1A bis Fig. 4C mit identischen Bezugszeichen versehen.

### Bester Weg zur Ausführung der vorliegenden Erfindung

Zur Vermeidung überflüssige Wiederholungen beziehen sich die nachfolgenden Erläuterungen hinsichtlich der Ausgestaltungen, Merkmale und Vorteile der vorliegenden Erfindung (soweit nicht anderweitig angegeben) auf sämtliche in Fig. 1A bis Fig. 4C dargestellten exemplarischen Ausgestaltungen von Vorrichtungen 100, 100', 100" gemäß der vorliegenden Erfindung; hierbei ist die Darstellung in Fig. 1A bis Fig. 4C nicht notwendigerweise maßstabs- und/oder funktionsgetreu, sondern dient lediglich der exemplarischen Veranschaulichung.

Wie Fig. 2A entnehmbar ist, weist der Photovoltaik-Konzentrator 100, 100', 100" einen sphärischen oder annähernd parabolischen Hohlspiegel 10, zum Beispiel aus polierter Aluminiumoberfläche oder aus verspiegeltem Kunststoff, wie etwa aus verspiegelten Polysterolplatten, auf, wobei der Hohlraum dieser Verspiegelung 10 mit einem Medium, wie etwa mit einem Gas, zum Beispiel mit Luft, oder mit einer transparenten Flüssigkeit, zum Beispiel mit Wasser, oder mit einem optisch transparenten Material, ausgefüllt sein kann.

Bei der Herstellung sphärischer oder annähernd parabolischer Konzentratorspiegel 10 mit verspiegelten Polysterolplatten oder auch mit anderen verspiegelten Materialien, wie zum Beispiel mit Acrylglasplatten oder mit Plexiglasplatten oder mit Polyesterplatten oder mit Polystyrolplatten, kann eine spezielle Pressform eingesetzt und sodann mit dieser Pressform über Druck und/oder über Temperatur die gewünschte Form des Spiegels 10 erzeugt werden, wobei zum Beispiel die Form eines parabolischen Spiegels mittels Annäherung über einen sphärischen Spiegel (oder auch umgekehrt) bereit gestellt werden kann.

Diese annähernd parabolische Spiegelform ist erhaltbar, wenn zum Beispiel eine verspiegelte Polysterolplatte zwischen zwei festen Haltepunkten in Form von Befestigungsklötzen 12 (vgl. Ausführungsbeispiel gemäß Fig. 1A) oder Befestigungsnuten 14 (vgl. Ausführungsbeispiel gemäß Fig. 1 B) eingespannt wird. Auch eine Realisierung mit einer Bodenplatte und mit unterschiedlichen Spiegeln ist möglich.

Die Einspannung zwischen den zwei Haltepunkten 12 (vgl. Fig. 1A) oder 14 (vgl. Fig. 1B) ergibt in sehr guter Näherung eine Parabelform der Gleichung y = a-x², die dann durch Druck auf den Scheitelpunkt in eine sphärische Form überführt werden kann. Dieser Druck kann über die Einspannung des Spiegels 10 in die Photovoltaikkonzentrator-Halterung erzeugt und aufrecht erhalten werden.

Dies ist eine Möglichkeit einer einfachen, kostengünstigen und flexiblen Herstellung von sphärischen und parabolischen Spiegeln 10 ohne die Gefahr einer Spiegelbeschädigung bei der Herstellung. Die transparente Einspannfläche 40 stellt außerdem einen guten Schutz des Spiegels 10 dar, womit das Konzept für Außenanwendungen geeignet ist.

Die in Bezug auf den Spiegelkörper 10 statisch montierten (handelsüblichen Standard-)Solarzellen 20 befinden sich unterhalb des Brennpunkts des Spiegels 10 in seiner durch die Kaustik hervorgerufenen Brennfläche. In

Fig. 2B ist eine der möglichen Anordnungen des photovoltaischen Absorbermittels, das heißt der Solarzellen 20 in der Brennebene oder -fläche des Spiegels 10 dargestellt.

Grundsätzlich kann das photovoltaische Absorbermittel 20 im Wesentlichen parallel (vgl. Ausführungsbeispiel gemäß Fig. 3B) oder im Wesentlichen senkrecht (vgl. Ausführungsbeispiel gemäß Fig. 3C) zur Brennebene oder Brennfläche des Spiegelkörpers 10 angeordnet sein.

Auch eine beliebige,
- insbesondere beliebig zur Brennebene oder Brennfläche des Spiegelkörpers 10 gewinkelte und/oder
- insbesondere beliebig zueinander gewinkelte
Anordnung der photovoltaischen Absorbermittel 20 ist möglich (vgl. Ausführungsbeispiel gemäß Fig. 3D). Hierbei bestimmen die geometrische Lage bzw. Positionierung der Photovoltaikmodule 20 sowie die Ausbildung der Photovoltaikmodule 20 die Konzentratorverstärkung und den Akzeptanzwinkel.

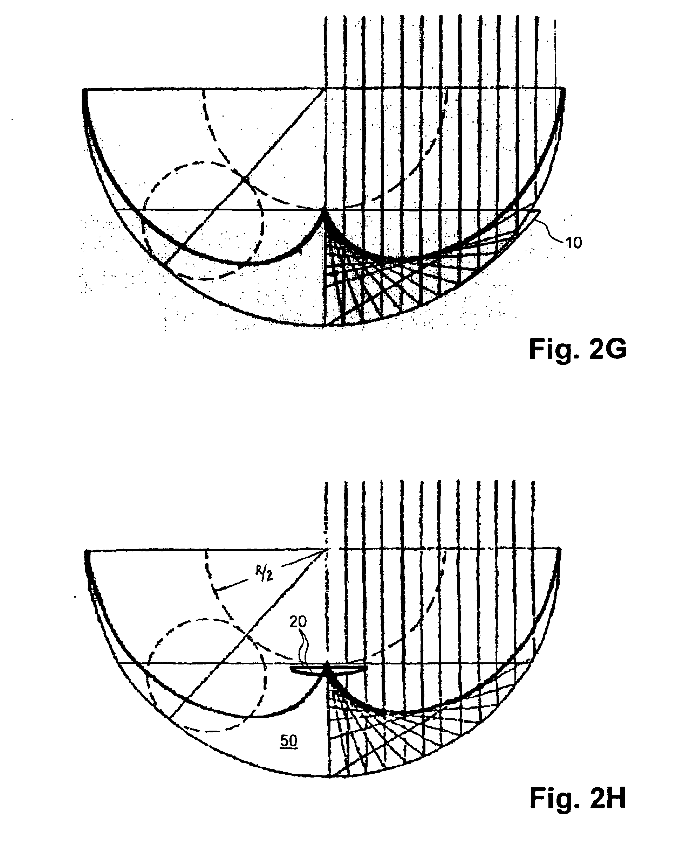

Aus der exemplarischen Darstellung der Fig. 3C und der Fig. 3D geht des Weiteren hervor, dass die Photovoltaikmodule 20 auch in Richtung des einstrahlenden Lichts (in Fig. 3C und in Fig. 3D also nach oben) angeordnet sein können. Auf diese Weise kann direkt einfallendes Licht, das ansonsten durch die Photovoltaikmodule 20 abgeschirmt würde, zusätzlich mit erfasst werden. Dies gilt auch für andere Anordnungen der photovoltaischen Absorber 20, wie zum Beispiel gemäß Fig. 2H.

In Fig. 2B bildet die gestrichelte Linie die sogenannte Hüllkurve (= Einhüllende oder Enveloppe) der Kaustik, wobei unter der Hüllkurve diejenige Kurve verstanden wird, die jede Kurve der Kurvenschar in einem Punkt berührt. Die Brennfläche ist die Verlängerung der strichpunktierten Linie.

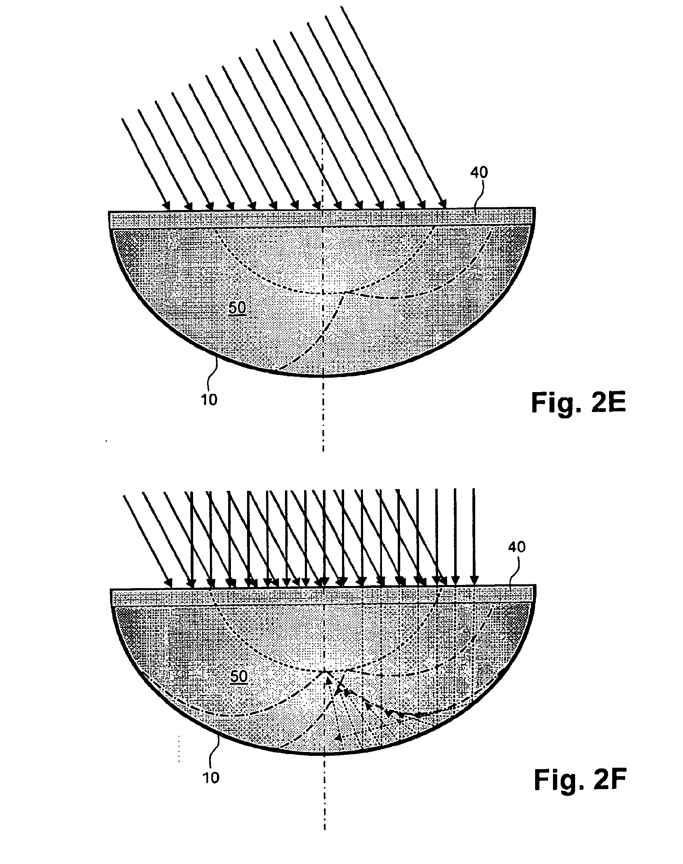

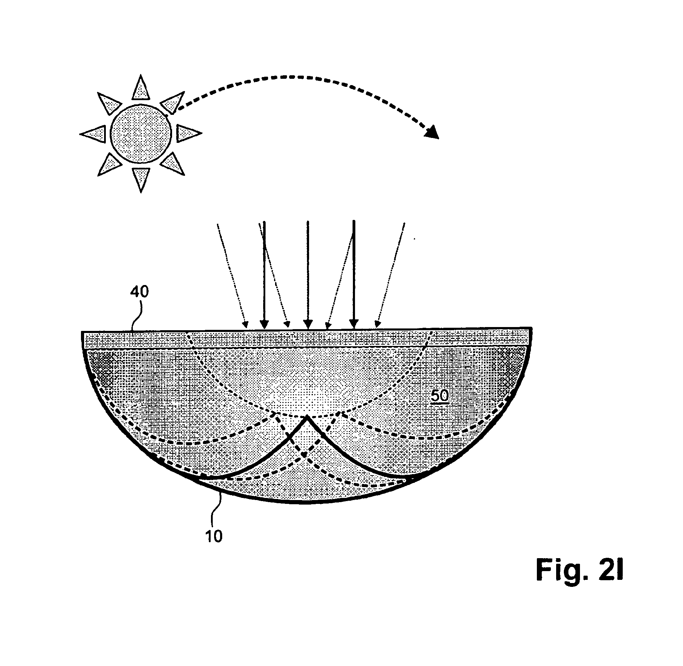

Wie Fig. 2E, Fig. 2F und Fig. 2I entnehmbar ist, wandert die Spitze der Kaustik-Hüllkurve oder Kaustik-Enveloppe mit dem Einfallswinkel der Strahlung, was bei einer sphärischen Spiegelanordnung in einem im Vergleich zu einem Parabolspiegel sehr großen Akzeptanzwinkel resultiert. Dieser Akzeptanzwinkel ist dann durch die geometrische Anordnung und Form der Photovoltaikmodule 20 bestimmt.

Im Ausführungsbeispiel gemäß Fig. 3C ist veranschaulicht, dass mittels eines dem Absorbermaterial oder Absorbermittel 20 in Strahlrichtung vorgelagerten oder vorgeschalteten oder vorgesetzten lichtbrechenden, optisch transparenten Elements 22 (= in Fig. 3C exemplarisch eine Linse) der durch die Kaustik bedingte Akzeptanzwinkel weiter vergrößert werden kann. Hierdurch wird berücksichtigt, dass die Brennspitze bzw. Brennfläche des sphärischen Spiegels 10 mit dem schräg einfallenden Licht (vgl. Fig. 2E und Fig. 2F) wandert (vgl. Fig. 2I). Durch Anbringen eines derartigen Elements 22 kann also optisch die Wirkung der Kaustik vergrößert und somit ein größerer Akzeptanzwinkel erhalten werden.

Mittels einer zweckmäßig ausgebildeten Nachführung, zum Beispiel in Winkelschritten von etwa fünf Grad bis etwa zehn Grad, kann der Akzeptanzwinkel sehr viel größer werden. Hierbei wird in bevorzugter Weise das photovoltaische Modul 20 innerhalb der Spiegelkalotte 10 gemäß der Brennpunktwanderung (vgl. Fig. 2I) nachgeführt, jedoch nicht der gesamte Spiegel.

Dies ist ein wesentlicher Unterschied in der die Kaustik ausnützenden, dem wandernden Brennpunkt (vgl. Fig. 2I) folgenden Nachführung eines sphärischen Spiegels zu einem parabolischen Spiegel gemäß der vorliegenden Erfindung und liegt in der Symmetrie des sphärischen Spiegels und der Wirkung der Kaustik begründet.

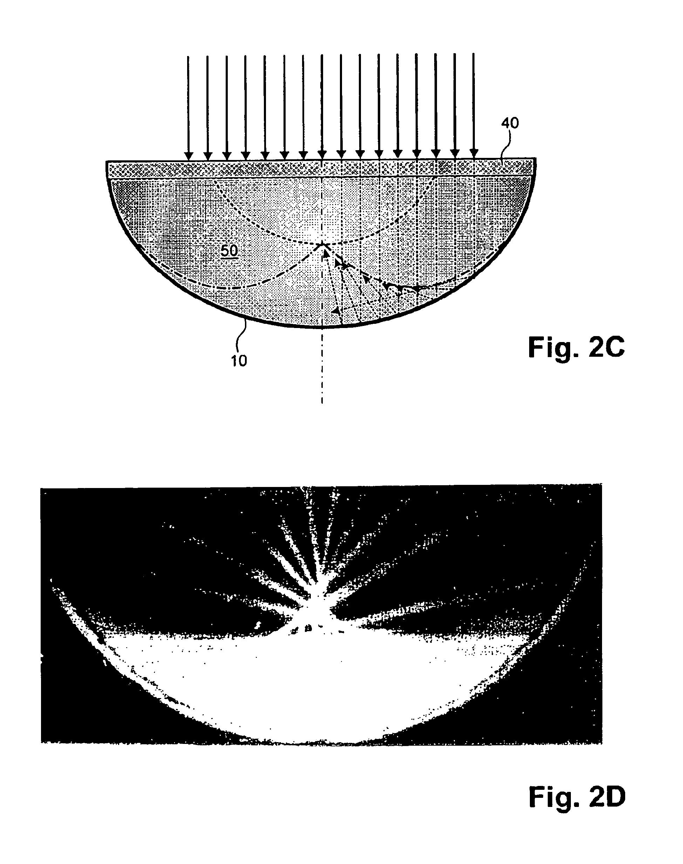

Gemäß Fig. 2D, Fig. 2G und Fig. 2H befindet sich die Spitze der Kaustik grundsätzlich auf dem Kreis mit Radius R/2. Bei schrägem Lichteinfall wandert die Spitze der Kaustik auf diesem Kreis (vgl. Fig. 2E, Fig. 2F, Fig. 2I).

Werden nun gemäß Fig. 2H die Photoabsorber 20 auf einem Körper mit Radius R/2 und mit Radius größer als R/2 angebracht, so wandert bei schräg einfallendem Licht die Kaustikspitze auf diesem kreisförmigen Körper, und es wird wiederum keine Nachführung benötigt (vgl. Fig. 2H). Als Photoabsorptionsmittel 20 sind hierbei Dünnschicht-Photomodule am besten geeignet, denn derartige Dünnschicht-Photomodule lassen sich auf Körper beliebiger Form aufbringen.

Die Verstärkung über die Kaustik hängt nicht allein von der Geometrie und/oder von der Formgebung der photovoltaischen Module 20 ab, sondern auch von der Gestaltung des Spiegels 10. Wird gemäß Fig. 2G in den äußeren Randbereichen des Spiegels 10 von der exakt sphärischen Form des Spiegels 10 in Richtung einer leicht parabolischen Form des Spiegels 10 abgewichen, so hat diese leichte Abweichung durchaus Einfluss auf die Konzentration in der Spitze der Hüllkurve.

Dies bedeutet mit anderen Worten, dass noch einen Kaustik-Effekt zeitigende Mischformen in der Gestaltung des Spiegels von erfindungswesentlichem Interesse sein können.

Alternativ oder ergänzend hierzu kann auch aus einer parabolischen Form des Spiegels 10 durch Druck über mindestens eine (Druck-)Platte in eine sphärische Form des Spiegels 10 übergegangen werden. In dieser Weise ergibt sich kein eindeutig definierter sphärischer Spiegel, sondern in zweckmäßiger Weise eine Mischform aus parabolischem Spiegel und sphärischem Spiegel. Soll ein eindeutig sphärischer Spiegel 10 bereit gestellt werden, hat die (Druck-)Platte eine sphärische Ausführung, oder der Kunststoffspiegel ist thermisch vorgeformt.

Anhand Fig. 2J (= Brennpunkt im Parabolspiegel mit senkrecht einfallendem Licht) und Fig. 2K (= Brennpunkt im Parabolspiegel mit schräg, nämlich unter etwa fünfzehn Grad einfallendem Licht) können die Unterschiede zwischen dem Einsatz eines sphärischen Spiegels 10 und dem Einsatz eines parabolischen Spiegels veranschaulicht werden.

Während beim parabolischen Spiegel Symmetrie bzw. Vollkommenheit (nur) bei senkrecht einfallendem Licht erzielt wird, wird beim sphärischen Spiegel 10 Symmetrie (auch) bei schräg einfallendem Licht erzielt, so dass bei schräg einfallendem Licht beim sphärischen Spiegel 10 kein Zerfallen des Brennpunkts, sondern lediglich ein Verschieben, das heißt "Wandern" des Brennpunkts erfolgt (vgl. Fig. 2I).

Die vorliegende Erfindung beruht nun auf der Nutzung dieses aus der Kaustik resultierenden wandernden, aber stabilen Brennpunkts bzw. dieser aus der Kaustik resultierenden wandernden, aber stabilen Brennfläche, wobei der wandernde Brennpunkt bzw. die wandernde Brennfläche den Vorteil hat, dass der sphärische Spiegel 10 grundsätzlich nicht nachgeführt werden muss.

Der Darstellung in Fig. 3A ist entnehmbar, dass das Konzentratorsystem 100, 100', 100" eine zum Zwecke der Lichtdurchlässigkeit bzw. der optischen Transparenz zum Beispiel aus (Acryl-)Glas gebildete Abdeckung 40 in Form einer Abdeckplatte aufweist, die mit dem Hohlspiegel 10 verbunden, insbesondere verschraubt, ist und zum Beispiel einen optischen Brechungsindex n von etwa 1,5 oder höher aufweisen kann.

Um diffuses und/oder schräg einfallendes Licht besser auszunutzen, kann die planare Abdeckung 40 (vgl. Fig. 1A, Fig. 1B, Fig. 3A, Fig. 4B) mit mindestens einer dünnen Beschichtung, insbesondere mit mindestens einer dünnen Folie und/oder mit mindestens einer dünnen Schicht unterschiedlichster Herstellungsweise, zur Lichtumlenkung versehen sein. Hierdurch ergibt sich eine äquivalente oder vergleichbare Wirkungsweise wie bei Brechungseffekten an optisch unterschiedlich dichten Medien.

Durch diese optionale technische Maßnahme kann der Winkelbereich des schräg einfallenden Lichts vergrößert werden. Die dünnen Folien und/oder dünnen Schichten können
- an der Oberseite und/oder an der Unterseite der Abdeckung 40 oder
- an der Oberseite eines massiven, optisch transparenten Körpers 50
angeordnet sein.

Um die Effizienz der Photovoltaik- oder Solarzellen 20 zu erhöhen, ist ein hohler, mit Gas, zum Beispiel mit Luft, durchströmter oder von Flüssigkeit, zum Beispiel von Wasser, durchflossener Kühlkörper 30 vorgesehen, auf den die eine exemplarische Dimensionierung von fünfzehn Millimetern aufweisenden Solarzellen 20 montiert sind (vgl. Fig. 3B).

Kommerziell sind Solarzellen als Platten im Format von etwa 150 Millimeter auf etwa 150 Millimeter erhältlich; auch Solarzellen-Riegel mit einer Dimensionierung von etwa 15 Millimeter auf etwa 150 Millimeter sind kommerziell verfügbar und bei der vorliegenden Erfindung einsetzbar.

Dieses mit Gas, zum Beispiel mit Luft, und/oder mit Flüssigkeit, zum Beispiel mit Wasser, betriebene Kühlsystem ist grundsätzlich optional, denn beim in Fig. 3B erzielbaren Konzentratorfaktor kann zwar mit einem Kühlgehäuse, jedoch auch ohne Flüssigkeit gearbeitet werden kann.

Diese Anordnung im Photovoltaik-Konzentrator 100, 100', 100" ermöglicht es, die Solarzellen 20 auch bei nicht senkrecht (vgl. Fig. 2C), sondern schräg (vgl. Fig. 2E) einfallendem Licht ohne Nachführung des Konzentrators 100, 100', 100" auszuleuchten. Der Kaustikeffekt bewirkt des Weiteren auch bei Streulicht und/oder bei diffusem Licht eine Lichtkonzentration in der Brennfläche und mithin ein optimales photovoltaisches Verhalten nicht nur bei direktem oder schrägem Lichteinfall, sondern auch bei diffusem Licht und/oder bei Streulicht. Hierbei ist zu bedenken, dass schräg einfallendes Licht und diffuses Licht den nordeuropäischen Lichtverhältnissen am ehesten entspricht.

Da mit der Vorrichtung 100, 100', 100" gemäß der vorliegenden Erfindung Konzentrationsverhältnisse zwischen einem Faktor größer als 1 und höheren Faktoren ohne weiteres realisierbar sind (der konkrete Konzentrationsfaktor hängt unter anderem von der Anordnung der Solarzellen 20 in der Brennfläche ab), reduziert sich der Siliziumaufwand bei der vorliegenden Erfindung gegenüber planaren Modulen um diesen Faktor, wodurch eine erhebliche Kostenreduktion bewirkt wird. Im Ausführungsbeispiel gemäß Fig. 3B ist ein Geometriefaktor von etwa 1:3 wiedergegeben.

In Fig. 4B ist der Querschnitt eines Photovoltaik-Konzentratormoduls 100 gemäß der vorliegenden Erfindung dargestellt. Diese modulförmige Vorrichtung 100 weist einen konkaven rinnen- oder wannenförmigen, im Querschnitt sphärisch oder annähernd parabelförmig gewölbten Spiegel 10 sowie eine Deckplatte 40 auf, an deren dem Spiegel 10 zugewandter Unterseite mittig der im Querschnitt rechteckförmige Kühlkörper 30 befestigt ist, in dessen unterem Bereich wiederum die Solarzellen 20 riegelförmig seitlich angeordnet sind.

Alternativ oder ergänzend kann eine Befestigung der Kühlkörper 30 auch am Boden des Spiegels 10 im Scheitelpunkt vorgenommen werden.

Das zum Beispiel unterhalb des Brennpunkts angeordnete Kühlelement 30 kann aus Aluminium gebildet sein und eine exemplarische Dimensionierung von fünfzehn Millimetern auf zwanzig Millimeter auf zwei Millimeter aufweisen.

Eine derartige, anhand Fig. 4B veranschaulichte Anordnung 100 ist mechanisch einfach und kostengünstig realisierbar, benötigt keine (oder lediglich eine sehr einfache interne) Nachführung und hat eine geschlossene, ebene Oberfläche in Form der Abdeckplatte 40, so wie dies auch bei konventionellen planaren Systemen nicht unüblich ist.

Da aufgrund der Wirkung des Spiegels 10 und der damit einher gehenden Kaustik der gesamte Konzentratorkörper 50 in seinem Inneren erhellt ist, ist das anhand Fig. 1A bis Fig. 4C veranschaulichte System auch im Wesentlichen unabhängiger vom Problem der Teilabschattung, die die Funktionsweise konventioneller planarer Systeme negativ beeinflusst.

Ein anhand Fig. 4C veranschaulichtes Photovoltaikkonzentratorfeld oder -panel 200 gemäß der vorliegenden Erfindung weist in seinem Aufbau eine Vielzahl (in Fig. 4C exemplarisch drei) der in Fig. 4B dargestellten modulartigen Photovoltaikvorrichtungen 100 unter einer geschlossenen planaren Oberfläche 40 auf.

Der modulare Aufbau der vorliegenden Erfindung ermöglicht es nicht nur, den Trägerkörper direkt in einem Trägerrahmen zu montieren, sondern erlaubt auch den Einsatz von Solarzellen aus anderen Materialen als Silizium. Dies unterscheidet den vorliegenden Photovoltaik-Konzentrator sehr wesentlich von konventionellen Konzentratoraufbauten und ist auch Voraussetzung für eine "Servicefreundlichkeit" des Systems.

Das aufgebaute Photovoltaikfeld oder Photovoltaikpanel 200 (vgl. Fig. 4C) hat eine exemplarische Fläche von etwa einem Quadratmeter und kann zum Beispiel zwanzig Einzelmodule aufweisen, von denen jedes eine exemplarische Dimensionierung von etwa einhundert Millimetern auf etwa fünfhundert Millimeter aufweist.

Aufgrund seiner planaren Oberfläche kann ein derartiges Photovoltaikfeld oder -panel 200 (vgl. Fig. 4C) fest auf einem Gebäude montiert werden, zum Beispiel in das Dach eines Gebäudes integriert werden.

Mit der vorliegenden Erfindung sind Solarstromverstärkungsfaktoren zwischen etwa 3 (<--> höherer Akzeptanzwinkel) und etwa 6 erzielbar. Typische Radien der sphärischen Spiegel 10 können zwischen etwa sechs Zentimetern und etwa zehn Zentimetern liegen, was einer typischen Bauhöhe des Konzentrators zwischen etwa vier Zentimetern und etwa sechs Zentimetern entspricht.

Bei einem Solarstromverstärkungsfaktor von etwa vier kann mit der vorliegenden Erfindung eine Siliziumersparnis von etwa 75 Prozent erzielt werden; bei höheren Verstärkungsfaktoren verbessert sich die Kostenreduktion.

Insgesamt beinhaltet die vorliegende Erfindung bei monokristallinen Photovoltaikmodulen ein Einsparpotential von etwa 25 Prozent bis etwa 35 Prozent (, wobei eine Effizienzerhöhung des Konzentrators durch Verbesserung des Arbeitspunkts des Photovoltaikmoduls hierbei noch gar nicht berücksichtigt ist).

Zusammenfassend kann also festgestellt werden, dass die sphärische Form der Spiegelkalotte 10 als Konzentrator für die Photovoltaikmodule
- in einer Kostenreduktion für das photovoltaische Material,
- durch die Kaustik in einem Konzentratoraufbau ohne Notwendigkeit der Nachführung des konzentrierenden Elements,
- in einem flachen Aufbau des Konzentrators (exemplarische Bauhöhe: etwa fünf Zentimeter) und
- in einer planaren Oberfläche
resultiert.

### Bezugszeichenliste

- 100: Vorrichtung zum Konzentrieren von einfallendem Licht, insbesondere von Sonnenlicht (= Ausführungsbeispiel gemäß Fig. 2B, Fig. 3B, Fig. 4B)
- 100': Vorrichtung zum Konzentrieren von einfallendem Licht, insbesondere von Sonnenlicht (= Ausführungsbeispiel gemäß Fig. 3C)
- 100": Vorrichtung zum Konzentrieren von einfallendem Licht, insbesondere von Sonnenlicht (= Ausführungsbeispiel gemäß Fig. 3D)
- 200: Photovoltaikfeld oder Photovoltaikpanel
- 10: Hohlspiegel oder Spiegel, insbesondere Spiegelkörper oder Verspiegelung
- 12: Haltepunkt, insbesondere Befestigungsklotz (= Ausführungsbeispiel gemäß Fig. 1A)
- 14: Haltepunkt, insbesondere Befestigungsnut (= Ausführungsbeispiel gemäß Fig. 1 B)
- 20: photovoltaisches Absorbermittel, insbesondere Photovoltaikelement oder Solarzelle, zum Beispiel Solarzellenplatte oder Solarzellenriegel
- 22: lichtbrechendes Element, insbesondere optisch transparenter lichtbrechender Körper, zum Beispiel Linse oder Prisma
- 30: Kühleinrichtung oder Kühlmittel
- 40: Abdeckung, insbesondere (Ab-)Deckplatte oder Einspannfläche oder (Ober-)Fläche, zum Beispiel planare und/oder transparente (Ab-)Deckplatte oder Einspannfläche oder ebene geschlossene Oberfläche, wie etwa Acrylglasplatte oder Plexiglasplatte oder Polyesterplatte oder Polysterolplatte oder Polystyrolplatte
- 50: Hohlkörper oder Körper

## Patentansprüche

1. Zum Konzentrieren von einfallendem Licht, insbesondere von Sonnenlicht, vorgesehene Vorrichtung (100; 100'; 100"), aufweisend mindestens einen statisch montierten rinnen- oder wannenförmigen, im Querschnitt sphärischen, Spiegelkörper (10), mittels dessen das einfallende Licht auf mindestens ein in Bezug auf den Spiegelkörper (10) statisch montiertes photovoltaisches Absorbermittel (20), insbesondere auf mindestens eine Solarzelle, zum Beispiel auf mindestens eine Solarzellenplatte oder auf mindestens einen Solarzellenriegel, umlenkbar ist,
**dadurch gekennzeichnet,**
- **dass** das photovoltaische Absorbermittel (20) in oder unterhalb der durch die Kaustik bewirkten Brennebene oder Brennfläche des Spiegelkörpers (10), insbesondere zwischen der Brennebene oder Brennfläche des Spiegelkörpers (10) und dem Scheitelpunkt des Spiegelkörpers (10), angeordnet ist und
- **dass** der Spiegelkörper (10) infolge der Kaustik und des daraus resultierenden wandernden Brennpunkts nachführungsfrei ist.

2. Vorrichtung gemäß Anspruch 1, **gekennzeichnet durch** mindestens ein dem photovoltaischen Absorbermittel (20) in Richtung des einfallenden Lichts und/oder in Richtung von reflektiertem Licht vorgelagertes lichtbrechendes, insbesondere optisch transparentes, Element (22), zum Beispiel **durch** mindestens eine Linse oder **durch** mindestens ein Prisma.

3. Vorrichtung gemäß Anspruch 1 oder 2, **gekennzeichnet durch** mindestens eine Nachführeinrichtung zum, insbesondere gemäß der Brennebenen- oder Brennflächen - oder Brennpunktwanderung erfolgenden, Nachführen des photovoltaischen Absorbermittels (20), insbesondere innerhalb der Kalotte des Spiegelkörpers (10), zum Beispiel in Winkelschritten von etwa fünf Grad bis etwa zehn Grad.

4. Vorrichtung gemäß mindestens einem der Ansprüche 1 bis 3, **gekennzeichnet**
- **durch** mindestens einen mit Gas, zum Beispiel mit Luft, oder mit Flüssigkeit, zum Beispiel mit Wasser, gefüllten Hohlkörper oder
- **durch** mindestens einen massiven, optisch transparenten Körper (50), wobei der Spiegelkörper (10) im Hohlkörper oder im Körper (50) integriert sein kann.

5. Vorrichtung gemäß mindestens einem der Ansprüche 1 bis 4, **gekennzeichnet durch** mindestens eine, insbesondere im Körper oder im Hohlkörper (50) integrierte, Kühleinrichtung (30), zum Beispiel aus Aluminium,
wobei das photovoltaische Absorbermittel (20) an der Kühleinrichtung (30), insbesondere
- im Wesentlichen parallel oder
- im Wesentlichen senkrecht oder
- unter mindestens einem beliebigen Winkel
zur Brennebene oder Brennfläche des Spiegelkörpers (10), angeordnet sein kann.

6. Vorrichtung gemäß mindestens einem der Ansprüche 1 bis 5, **gekennzeichnet durch** mindestens eine den Spiegelkörper (10) einschließlich des photovoltaischen Absorbermittels (20) abdeckende, optisch transparente Abdeckung (40), insbesondere Abdeckplatte oder Einspannfläche, zum Beispiel aus Acryl oder aus Glas.

7. Vorrichtung gemäß Anspruch 6, **dadurch gekennzeichnet, dass** die Abdeckung (40) mit mindestens einer lichtumlenkenden Beschichtung, insbesondere mit mindestens einer lichtumlenkenden Folie und/oder mit mindestens einer lichtumlenkenden Schicht, versehen ist.

8. Vorrichtung gemäß Anspruch 7, **dadurch gekennzeichnet, dass** die lichtumlenkende Beschichtung
- an der dem photovoltaischen Absorbermittel (20) zugewandten Seite der Abdeckung (40) und/oder an der vom photovoltaischen Absorbermittel (20) abgewandten Seite der Abdeckung (40) oder
- an der Oberseite des massiven, optisch transparenten Körpers (50) angeordnet ist.

9. Vorrichtung gemäß Anspruch 5 und gemäß mindestens einem der Ansprüche 6 bis 8, **dadurch gekennzeichnet, dass** die Kühleinrichtung (30)
- an der dem Spiegelkörper (10) zugewandten Unterseite der Abdeckung (40) und/oder
- am Spiegelkörper (10), insbesondere im Scheitelpunkt des Spiegelkörpers (10), zum Beispiel am Boden des Spiegelkörpers (10),
angeordnet ist.

10. Photovoltaikfeld oder Photovoltaikpanel (200), aufweisend mehrere Vorrichtungen (100; 100'; 100") gemäß mindestens einem der Ansprüche 1 bis 9.

11. Verfahren zum Konzentrieren von einfallendem Licht, insbesondere von Sonnenlicht, mittels des Kaustikeffekts mindestens eines statisch montierten rinnen- oder wannenförmigen, im Querschnitt sphärischen, Spiegelkörpers (10), durch den das einfallende Licht auf mindestens ein in Bezug auf den Spiegelkörper (10) statisch montiertes photovoltaisches Absorbermittel (20), insbesondere auf mindestens eine Solarzelle, zum Beispiel auf mindestens eine Solarzellenplatte oder auf mindestens einen Solarzellenriegel, umgelenkt wird,
**dadurch gekennzeichnet,**
- **dass** das photovoltaische Absorbermittel (20) in oder unterhalb der durch die Kaustik bewirkten Brennebene oder Brennfläche des Spiegelkörpers (10), insbesondere zwischen der Brennebene oder Brennfläche des Spiegelkörpers (10) und dem Scheitelpunkt des Spiegelkörpers (10), angeordnet wird und
- **dass** der Spiegelkörper(10) infolge der Kaustik und des daraus resultierenden wandernden Brennpunkts nachführungsfrei ist.

12. Verwendung mindestens einer Vorrichtung (100; 100'; 100") gemäß mindestens einem der Ansprüche 1 bis 9 und/oder mindestens eines Photovoltaikfelds oder Photovoltaikpanels (200) gemäß Anspruch 10 zum Konzentrieren von einfallendem Licht, insbesondere von Sonnenlicht, auf mindestens ein photovoltaisches Absorbermittel (20), insbesondere auf mindestens eine Solarzelle, zum Beispiel auf mindestens eine Solarzellenplatte oder auf mindestens einen Solarzellenriegel.

## Claims

1. A device (100; 100'; 100") provided for concentrating incident light, particularly sunlight, exhibiting at least one statically assembled channel-shaped or trough-shaped mirror (10) which is spherical in cross-section, by means of which the incident light can be deflected onto at least one photovoltaic absorber means (20) which is statically assembled in relation to the mirror (10), particularly on at least one solar cell, for example on at least one solar cell panel or on at least one solar cell bar,
**characterized in that**
- the photovoltaic absorber means (20) is disposed in or beneath the focal plane or focal surface of the mirror (10) produced by the caustic, particularly between the focal plane or focal surface of the mirror (10) and the apex of the mirror (10) and
- that the mirror (10) is free from tracking as a consequence of the caustic and the freely moving focal point resulting from this.

2. The device according to claim 1, **characterized by** at least one light-refracting, particularly optically transparent, element (22) placed in front of the photovoltaic absorber means (20) in the direction of the incident light and/or in the direction of the reflected light, for example by at least one lens or by at least one prism.

3. The device according to claim 1 or 2, **characterized by** at least one tracking mechanism for tracking the photovoltaic absorber means (20), particularly according to the movement of the focal plane or focal surface or focal point, particularly within the calotte of the mirror (10), for example in angle stages of roughly five to roughly ten degrees.

4. The device according to at least one of the claims 1 to 3, **characterized by**
- at least one hollow body filled with gas, for example air, or with liquid, for example water, or
- at least one solid, optically transparent body (50),
wherein the mirror (10) may be integrated in the hollow body or in the body (50).

5. The device according to at least one of the claims 1 to 4, **characterized by** at least one cooling mechanism (30) made of aluminum, for example, integrated in the body or in the hollow body (50),
wherein the photovoltaic absorber means (20) may be disposed on the cooling mechanism (30), particularly
- essentially parallel to or
- essentially perpendicular to
- at least an angle of any size to
the focal plane or focal surface of the mirror (10).

6. The device according to at least one of the claims 1 to 5, **characterized by** at least one optically transparent cover (40), particularly a cover plate or clamping surface, made of acrylic or gas, for example, covering the mirror (10) including the photovoltaic absorber means (20).

7. The device according to claim 6, **characterized in that** the cover (40) is provided with at least one light-deflecting coating, particularly with at least one light-deflecting film and/or with at least one light-deflecting layer.

8. The device according to claim 7, **characterized in that** the light-deflecting coating is disposed
- on the side of the cover (40) turned away from the photovoltaic absorber means (20) and/or on the side of the cover (40) turned away from the absorber means (20) or
- on the upper side of the solid, optically transparent body (50).

9. The device according to claim 5 and in accordance with at least one of the claims 6 to 8, **characterized in that** the cooling mechanism (30) is disposed
- on the underside of the cover (40) turned away from the mirror (10) and/or
- on the mirror (10), particularly at the apex of the mirror (10), for example on the base of the mirror (10).

10. A photovoltaic field or photovoltaic panel (200) exhibiting a plurality of devices (100; 100'; 100") in accordance with at least one of the claims 1 to 9.

11. A method of concentrating incident light, particularly sunlight, by means of the caustic effect of at least one statically assembled channel-shaped or trough-shaped mirror (10) which is spherical in cross-section, by means of which the incident light is deflected onto at least one photovoltaic absorber means (20) which is statically assembled in relation to the mirror (10), particularly on at least one solar cell, for example on at least one solar cell panel or on at least one solar cell bar, **characterized in that**
- the photovoltaic absorber means (20) is disposed in or beneath the focal plane or focal surface of the mirror (10) produced by the caustic, particularly between the focal plane or focal surface of the mirror (10) and the apex of the mirror (10) and
- that the mirror (10) is free from tracking as a consequence of the caustic and the freely moving focal point resulting from this.

12. Use of at least one device (100; 100'; 100") in accordance with at least one of the claims 1 to 9 and/or at least one photovoltaic field or photovoltaic panel (200) according to claim 10 for concentrating incident light, particularly sunlight, on at least one photovoltaic absorber means (20), particularly on at least one solar cell, for example on at least one solar cell panel or on at least one solar cell bar.

## Revendications

1. Dispositif (100; 100' ; 100") prévu pour concentrer la lumière incidente, notamment la lumière du soleil, présentant au moins un corps de miroir (10) monté statiquement en forme de rigole ou de bac, sphérique en coupe transversale, au moyen duquel la lumière incidente peut être défléchie sur au moins un moyen absorbeur (20) photovoltaïque monté statiquement par rapport au corps de miroir (10), notamment sur au moins une cellule solaire, par exemple sur au moins une plaque de cellule solaire ou sur au moins une traverse de cellule solaire,
**caractérisé en ce que**
- le moyen absorbeur photovoltaïque (20) est disposé dans ou au-dessous du plan focal ou de la surface focale provoqué par la caustique du corps de miroir (10), notamment entre le plan focal ou la surface focale du corps de miroir (10) et le point culminant du corps de miroir (10), et
- le corps de miroir (10) est exempté de repositionnement en conséquence de la caustique et du point focal migrant qui en résulte.

2. Dispositif selon la revendication 1, **caractérisé par** au moins un élément (22) rompant la lumière, notamment optiquement transparent prépositionné avant le moyen absorbeur (20) photovoltaïque dans la direction de lumière incidente et/ou dans la direction de la lumière réfléchie, par exemple par au moins une lentille ou par au moins un prisme.

3. Dispositif selon les revendications 1 ou 2, **caractérisé par** au moins un dispositif de repositionnement pour, notamment en fonction des plans focaux ou des surfaces focales ou de la migration de point focal, repositionner le moyen absorbeur photovoltaïque (20), notamment à l'intérieur de la calotte du corps de miroir (10), par exemple dans des incréments d'environ cinq degrés à environ dix degrés.

4. Dispositif selon au moins une des revendications 1 à 3, **caractérisé par** :
- au moins un corps creux rempli par un gaz, par exemple par de l'air, ou par un liquide, par exemple par de l'eau ou
- au moins un corps optiquement transparent massif (50),
dans lequel le corps de miroir (10) peut être intégré dans le corps creux ou dans le corps (50).

5. Dispositif selon au moins une des revendications 1 à 4, **caractérisé par** au moins un dispositif de refroidissement, notamment intégré dans le corps ou dans le corps creux (50), par exemple en aluminium,
dans lequel le moyen absorbeur photovoltaïque (20) peut être disposé sur le dispositif de refroidissement (30), notamment
- essentiellement parallèle ou
- essentiellement perpendiculaire ou
- au moins sous un angle au choix par rapport au plan focal ou à la surface focale du corps de miroir (10).

6. Dispositif selon au moins une des revendications 1 à 5, **caractérisé par** au moins un couvercle (40) optiquement transparent, recouvrant le corps de miroir (10) y compris le moyen absorbeur photovoltaïque (20), notamment une plaque de couvercle ou une surface annulaire, par exemple en acrylique ou en verre.

7. Dispositif selon la revendication 6, **caractérisé en ce que** le couvercle (40) est pourvu d'au moins un revêtement déflecteur de lumière, notamment d'au moins un film déflecteur de lumière et/ou d'au moins une couche déflectrice de lumière.

8. Dispositif selon la revendication 7, **caractérisé en ce que** le revêtement déflecteur de lumière est disposé
- sur le côté du couvercle (40) tourné vers le moyen absorbeur photovoltaïque (20) et/ou sur le côté du couvercle (40) qui se détourne du moyen absorbeur photovoltaïque (20) ou
- sur le côté supérieur du corps massif, optiquement transparent (50).

9. Dispositif selon la revendication 5 et selon au moins une des revendications 6 à 8, **caractérisé en ce que**, le dispositif de refroidissement (30) est disposé
- sur le côté inférieur du couvercle (40) tourné vers le corps de miroir (10) et/ou
- sur le corps de miroir (10), notamment dans le point culminant du corps de miroir (10), par exemple sur la base du corps de miroir (10).

10. Champ photovoltaïque ou panneau photovoltaïque (200), présentant plusieurs dispositifs (100; 100' ; 100") selon au moins une des revendications 1 à 9.

11. Procédé de concentration de lumière incidente, notamment de lumière du soleil, au moyen de l'effet caustique d'au moins un corps de miroir (10) monté statiquement en forme de rigole ou de bac, sphérique en coupe transversale, par l'intermédiaire duquel la lumière incidente est défléchie sur au moins un moyen absorbeur photovoltaïque (20) monté statiquement par rapport au corps de miroir (10), notamment sur au moins une cellule solaire, par exemple sur au moins une plaque de cellule solaire ou sur au moins une traverse de cellule solaire,
**caractérisé en ce que**
le moyen absorbeur photovoltaïque (20) est disposé dans ou au-dessous du plan focal ou de la surface focale provoqué par la caustique du corps de miroir (10), notamment entre le plan focal ou la surface focale du corps de miroir (10) et le point culminant du corps de miroir (10), et
le corps de miroir (10) est exempté de repositionnement en conséquence de la caustique et du point focal migrant qui en résulte.

12. Utilisation d'au moins un dispositif (100 ; 100' ; 100") selon au moins une des revendications 1 à 9 et/ou au moins d'un champ photovoltaïque ou d'un panneau photovoltaïque (200) selon la revendication 10 pour concentrer la lumière incidente, notamment la lumière du soleil, sur au moins un moyen absorbeur photovoltaïque (20), notamment sur au moins une cellule solaire, par exemple sur au moins une plaque de cellule solaire ou sur au moins une traverse de cellule solaire.
